Europäisches Patentamt

European Patent Office

Office européen des brevets

(11) Publication number: **0 175 152**
A2

(12) **EUROPEAN PATENT APPLICATION**

(21) Application number: **85110330.9**

(22) Date of filing: **19.08.85**

(51) Int. Cl.⁴: **G 05 F 3/20**

(30) Priority: **21.08.84 US 642837**

(43) Date of publication of application: **26.03.86**
**Bulletin 86/13**

(84) Designated Contracting States: **DE FR GB IT**

(71) Applicant: **LATTICE SEMICONDUCTOR CORPORATION,**
**10300 SW Greenburg Road, Portland Oregon 97223 (US)**

(72) Inventor: **Moench, Jerry D., 11305 Spicewood Parkway,**
**Austin Texas 78750 (US)**
Inventor: **Tesch, Rodney C., 9830 S.W. Buckskin Terrace,**
**Beaverton Oregon 97005 (US)**

(74) Representative: **Reinländer & Bernhardt Patentanwälte,**
**Orthstrasse 12, D-8000 München 60 (DE)**

(54) **A method and an apparatus to prevent latchup in a CMOS device.**

(57) An apparatus and a method is disclosed to prevent latchup in a CMOS device and, in particular, during the power-up phase of the CMOS device. A switching transistor is interposed between the power $V_{DD}$ and the P-channel transistors. A control circuit controls the switching transistor, such that the switching transistor is turned off when power is initially applied to the CMOS device. The substrate of either the N channel MOS transistor or the P channel MOS transistor, preferably both, is biased with the latter being biased above $V_{DD}$ and the former being biased to a negative potential. Once the substrate of the N channel MOS transistor and the P channel MOS transistor are biased, the switching transistor is then turned on permitting power to be applied to the P channel transistors.

-1-

## Description

### A METHOD AND AN APPARATUS TO
### PREVENT LATCHUP IN A CMOS DEVICE

Technical Field

The present invention relates to a method and an apparatus to prevent latchup in a CMOS device and, more particularly, to a method and an apparatus to prevent latchup in a CMOS device during the power-up phase of a CMOS device.

Background Art

CMOS devices are well-known in the art. CMOS is an acronym for Complementary Metal Oxide Semiconductor. A CMOS device will always have at least one P channel MOS transistor with an N channel MOS transistor - hence the term Complementary. CMOS devices utilize MOS field effect transistors (FET), which are unipolar, i.e., a single transistor uses either electrons or holes for conduction, but not both. An FET transistor is characterized by a source, a drain, with a channel therebetween, a gate to regulate the conduction of the electrons or holes migrating in the channel, and a substrate in which the source and the drain is constructed.

*R.c.1.*
*gam*

Latchup is a condition which occurs as a result of a region within one type of MOS transistor (e.g., P channel MOS transistor) being proximate to a region in the complementary MOS transistor (e.g., N channel MOS transistor). As the dimensions of semiconductor devices are further reduced by greater size integration, latchup, which is the "cross talk" of one transistor to the complementary transistor, becomes an increasingly severe problem. Furthermore, as the scale of integration increases, parasitic noise and the like which can trigger latchup assume greater importance.

-2-

In the prior art, a number of techniques have been devised to prevent latchup. First, guard bands have been placed around a particular channel type transistor to insulate it from its complementary type MOS transistor. However, guard bands require a portion of the CMOS device dedicated to non-productive use. In large scale integration, the amount of "real estate" or area which can be used for such purpose becomes increasingly difficult to find. Secondly, metal strapping, i.e., low resistance connections to the substrates of the two types of MOS transistors have been made. These low resistive connections served to break the path of interconnection from one type of MOS transistors to its complementary transistor. Finally, low-resistive path in the body of the semiconductor, much like a low resistance back plane, has been offered as a solution.

In all of these prior art techniques, however, the problem of latchup has not been satisfactorily resolved. Moreover, the problem of latchup during the power-up phase of the CMOS device has never been addressed.

Summary Of The Invention

In accordance with the present invention, a circuit is disclosed to prevent latchup in a CMOS device. A first transistor means is connected between a voltage source and the CMOS device for connecting and disconnecting the voltage source to the CMOS device. A controlling means controls the first transistor means for connecting and disconnecting the voltage source to the CMOS device. Means is provided for biasing one of the substrates of the P channel transistor or the N channel transistor. The controlling means disconnects the voltage source to the CMOS device during power-up and connects the voltage source to the CMOS device

after the substrate of the P channel transistor or the N channel transistor is biased.

A method is also disclosed for operating the CMOS device. One of the substrates of either the P channel MOS transistor or the N channel MOS transistor is biased. Power is then applied to the CMOS device.

## Brief Description Of The Drawings

Fig. 1a is a schematic cross-sectional area of a CMOS device showing the P body with an N type well forming the N channel MOS transistor and P channel MOS transistor, respectively.

Fig. 1b is a circuit diagram of the P-channel MOS transistor and N-channel MOS transistor of Fig. 1a.

Fig. 2 is a schematic cross-sectional view of another CMOS device with an N body and a P well, showing the P channel MOS transistor and N channel MOS transistor, respectively.

Fig. 3 is a schematic circuit diagram of the parasitic bipolar network of Fig. 1 or Fig. 2.

Fig. 4 is a schematic circuit diagram of the parasitic bipolar network with the apparatus of the present invention.

Fig. 5 is a schematic circuit diagram of the control means shown in Fig. 4.

Fig 6 is a schematic diagram of the substrate pump No. 1 shown in Fig. 4.

Fig. 7 is a schematic circuit diagram of the substrate pump No. 2 shown in Fig. 4.

## Detailed Description Of The Drawings

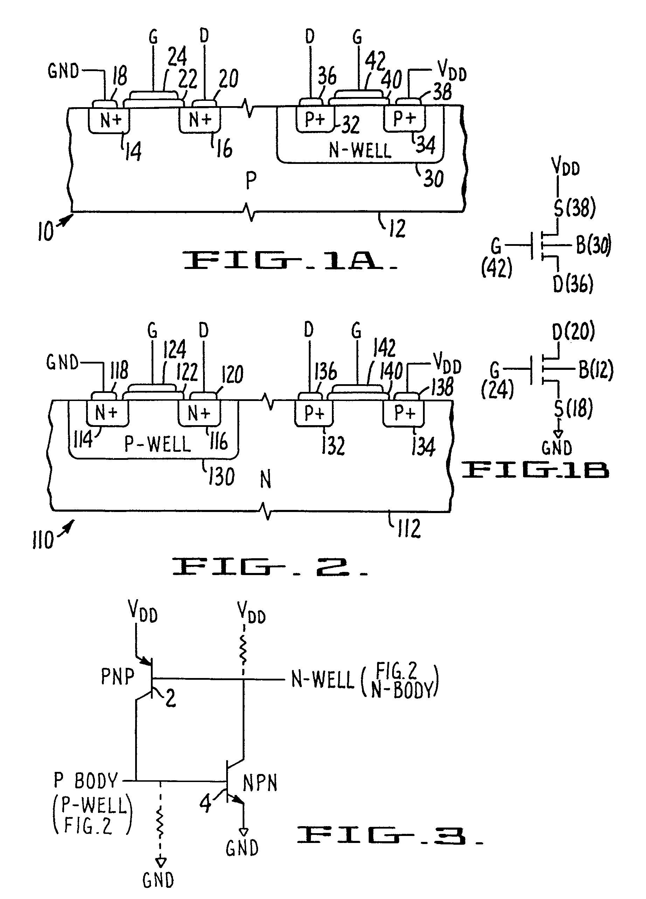

Referring to Fig. 1a, there is shown a CMOS device 10, to which the apparatus and the method of the present invention are applicable. The CMOS device 10 comprises a body of P type single crystaline semiconductor 12, typically made out of silicon. A

-4-

first region 14 of an $N^+$ material and a second region 16 of an $N^+$ material are deposited in the body 12. A first metallized layer 18 and a second metallized layer 20, deposited on the first region 14 and the second region 16, respectively, form the contacts therefor. A first oxide layer 22 is on the body 12. A third metallized layer 24 is on the first oxide layer 22. Thus, the foregoing comprises a N-channel MOS transistor, wherein the gate is the connection to the third metallized layer 24, the drain is the connection to the second metallized layer 20, and the source is the connection to the first metallized layer 18. The substrate of the N-channel MOS transistor is the body 12. In Fig. 1b, the substrate is labelled as B.

The P channel MOS transistor is formed in an N-type well 30 within the body 12. A third region 32 of a $P^+$ material and a fourth region 34 of a $P^+$ material are in the N-type well 30. A fourth and fifth metallized layers 36 and 38, respectively, are on the third and fourth $P^+$ regions 32 and 34, respectively, forming the connections to the third and fourth $P^+$ regions 32 and 34. A second oxide layer 40 is on the N well 30. A sixth metallized layer 42 is on the second oxide layer 40. The P channel MOS transistor is thus formed. The P channel MOS transistor comprises a source (the connection to the fifth metallized layer 38), a gate (the connection to the sixth metallized layer 42), a drain (the connection to the fourth metallized layer 36) and a substrate (the N well 30). This is schematically shown in Fig. 1b.

Typically, in a CMOS device, a positive voltage source, $V_{DD}$, is applied to the source of the P channel MOS transistor with the source of the N-channel MOS transistor connected to ground (GND). In the CMOS device 10, $V_{DD}$ is connected to the sixth metallized layer 38.

-5-

Referring to Fig. 2, there is shown another CMOS device 110. The CMOS device 110 is identical in its circuit performance to the CMOS device 10, shown in Fig. 1a. However, as can be seen in Fig. 2, the CMOS device 110 comprises a P-channel MOS transistor in the body 112 with an N channel MOS transistor in the P-type well 130, within the body 112.

Latchup is a condition which occurs as a result of the interconnection of regions within the P channel MOS transistor and the adjacent N channel MOS transistor. Referring to Fig. 3, there is a schematic circuit diagram of the interconnections of the CMOS device 10 or the CMOS device 110. The PNP bipolar transistor 2, shown in Fig. 3, is the result of the interconnection of the P region (34 or 134) connected to the N region (N well 30 of Fig. 1a or N body 112 of Fig. 2) with the P region (P body 12 of Fig. 1a or P well 130 of Fig. 2). The NPN bipolar transistor 4 is the result of the interconnection of the N region (N well 30 shown in Fig. 1a or the N body 112 of Fig. 2) connected to the P region (P body 12 of Fig. 1a or P well 130 of Fig. 2) with the N region (14 or 114). Hereinafter, the discussions will be limited to the CMOS device 10 of Fig. 1a. However, as discussed hereinabove and as is apparent, the problem of latchup, as well as the apparatus and method of the present invention to solve the problem of latchup is equally applicable to the CMOS device 110 of Fig. 2.

Latchup occurs when the P body 12 becomes more positive than the N region 14, thereby turning on the NPN transistor 4. When NPN transistor 4 turns on, the N well 30 will reach a potential below $V_{DD}$. When N well 30 falls sufficiently below $V_{DD}$, it turns on the PNP transistor 2. This, in turn, pulls the P body 12 to yet a higher positive potential, turning the NPN transistor 4 on more. In short, latchup is like positive feedback in that it is a vicious cycle. When latchup occurs, the only recourse is to power down the CMOS device 10 and then power up slowly.

The typical causes for the P body 12 to become positive to turn on the NPN transistor 4 all usually occur during the power-up phase of the CMOS device 10. These include 1) capacitive coupling between $V_{DD}$ and P body 12 to pull P body 12 to a positive potential; 2) impact ionization in the P body 12 near the second region 16 of $N^+$ can cause the production of electron hole pairs. The holes migrate through the P body 12 forming the positive potential; and 3) impact $R.C.1.$ ionization in the N well 30 near the third region 36 of $\mathcal{I}\mathcal{I}\mathcal{m}$ the $P^+$ also can cause the generation of electron hole pairs. The electrons are swept into the well 30, rendering it less positive than $V_{DD}$, thereby starting the latchup process.

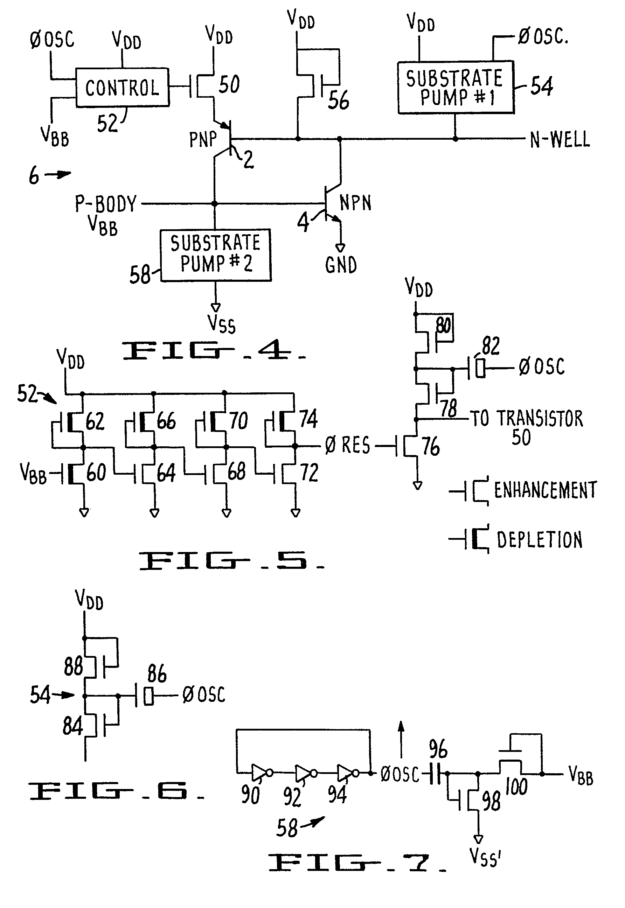

Referring to Fig. 4, there is shown an apparatus 6 of the present invention suitable for use with the CMOS device 10 (or 110) to control latchup. The apparatus 6 comprises a first MOS enhancement type transistor 50 connected between $V_{DD}$ and the source of the P channel MOS transistor. A control means 52 (shown in greater detail in Fig. 5) controls the operation of the first transistor 50. A first substrate pump 54 is connected to the N well 30. A second MOS enhancement transistor 56 also connects the N well to $V_{DD}$. A second substrate pump 58 is connected to the P body 12. The first transistor 50 is for connecting and disconnecting the voltage source $V_{DD}$ to the CMOS device 10. The control means 52 controls the first transistor 50 for connecting or disconnecting the voltage source $V_{DD}$ to the CMOS device 10. The first substrate pump 54 biases $R.C.i$ the substrate of the P channel transistor ( P body 12) $q\mathcal{L}m$ whereas the second substrate pump 58 biases the substrate of the N channel transistor (N well 30). The

$R.C.1.$

control means 52 controls the first transistor 50 to disconnect the voltage source $V_{DD}$ to the CMOS device 10 during power-up and connects the voltage source $V_{DD}$ to the CMOS device 10 after the substrate of either the P channel transistor or the N channel transistor is biased. Preferably $V_{DD}$ is connected after both substrates are biased.

Referring to Fig. 5, there is shown in greater detail the control means 52. The voltage of the P body 12 $V_{BB}$ is supplied to the gate of a third depletion transistor 60. The drain of the third depletion transistor 60 is connected to the source and the gate of a fourth depletion transistor 62. The drain of the third depletion transistor 60 is also connected to the gate of a fifth enhancement transistor 64. The drain of the fifth enhancement transistor 64 is connected to the source and gate of a sixth depletion transistor 66. The drain of the fifth enhancement transistor 64 is also connected to the gate of a seventh enhancement transistor 68. The drain of the seventh enhancement transistor 68 is connected to the source and the gate of the eighth depletion transistor 70. The drain of the seventh enhancement transistor 68 is connected to the gate of the ninth enhancement transistor 72. The drain of the ninth enhancement transistor 72 is connected to the source and the gate of the tenth depletion transistor 74. The fourth, sixth, eighth and tenth depletion transistors 62, 66, 70 and 74, respectively, all have their drains connected to voltage source $V_{DD}$. The drain of the ninth enhancement transistor 72 forms the output ØRES.

ØRES is connected to the gate of a eleventh enhancement transistor 76. The drain of the eleventh enhancement transistor 76 is connected to the gate of the first transistor 50. The drain of the eleventh enhancement transistor 76 is also connected to a circuit which is identical to the circuit of the first substrate pump 54.

Referring to Fig. 6, there is shown the schematic circuit diagram of the first substrate pump 54. The first substrate pump 54 comprises a thirteenth enhancement transistor 84 whose source is connected to the N well 30, and whose gate and drain are connected together to the gate of a fourteenth enhancement transistor 86. The fourteenth enhancement transistor 86 has its source and drain connected together to receive the signal from ØOSC. The drain of the thirteenth enhancement transistor 84 is connected to the source of the fifteen enhancement transistor 88. The gate and the drain of the fifteen enhancement transistor 88 are connected together and to $V_{DD}$.

Referring to Fig. 7, there is shown a schematic circuit diagram of the second substrate pump 58. The second substrate pump 58 comprises a first inverter 90, a second inverter 92, and a third inverter 94. Each of the first, second, and third inverters 90, 92 and 94, respectively, are connected with the output of one inverter supplied as the input to the other inverter. The output of the third inverter 94 is ØOSC. ØOSC, in addition to other connections, is also connected to a capacitor 96. The capacitor 96 is coupled to a sixteenth enhancement transistor 98, whose drain and gate are connected to the capacitor 96. The source of the sixteen enhancement transistor 98 is connected to $V_{SS}$, which is ground potential. The drain and gate of the sixteenth enhancement transistor 98 are also connected to the source of the seventeenth transistor 100, whose gate and drain are connected together and are connected to the P body 12, $V_{BB}$.

In the operation of the apparatus 6 of the present invention, when power $V_{DD}$ is initially supplied to the CMOS device 10, the voltage potential of the P body 12,

-9-

$V_{BB}$, will initially be slightly positive. Through the control circuit 52, a positive $V_{BB}$ will produce a high ØRES. When ØRES is high, eleventh enhancement transistor 76 conducts, thereby preventing current flow from $V_{DD}$ to the CMOS device 10 through the first transistor 50. Thus, initially, first transistor 50 is turned off. Although a positive $V_{BB}$ will turn on the NPN transistor 4, latchup will not occur because the PNP transistor 2 has no emitter current, i.e., $V_{DD}$ is not connected to the PNP transistor 2. Thus, there is no latchup during the initial phase of the power-up.

When power is turned on, power is supplied to the first, second, and the third inverters 90, 92 and 94, respectively. Since there is an odd number of inverters, the three inverters will continuously oscillate between high and low, forming a continuously oscillating waveform. This is the signal ØOSC. ØOSC is supplied to the capacitor 96 as well as to the control circuit 52 and the first substrate pump 54. ØOSC oscillates to bring $V_{BB}$ down a negative voltage below $V_{SS}$. ØOSC brings $V_{BB}$ from the initial positive voltage to zero and then to a slightly negative voltage, such as -1.5V. At that point, $V_{BB}$ is sufficiently negative that the third depletion transistor 60 has reduced drain current. When the depletion transistor 60 has reduced current, ØRES goes low. This turns off the eleventh transistor 76.

To turn on the first transistor 50, the gate of the first transistor 50 must be brought to a positive voltage. Thus, the pump, similar to the first substrate pump 54, connected to the gate of the first transistor 50 begins to bring the voltage potential up, from substantially zero volts. When ØOSC reaches eighteenth transistor 82, which acts like a capacitor, ØOSC turns on nineteenth transistor 78. With each oscillation of ØOSC, it incrementally increases the potential to the gate of the first transistor 50. A positive voltage on the gate of the first transistor 50 will cause it to turn on. As the gate voltage increases, the voltage on the source of the first transistor 50 will also increase. When the voltage on the gate of the transistor 50 is brought above $V_{DD}$, the source of the transistor 50 will be arbitrarily close to $V_{DD}$.

Although the CMOS device 10 is now powered up, the potential of the P body 12 is negative such that latchup will not occur because the NPN transistor 4 will not turn on. Furthermore, the second substrate pump 58 continues its pumping activity until $V_{BB}$ is brought to approximately -3 volts. Thus, subsequently, in order for latchup to occur as a result of the potential in the P body 12, the potential in the P body 12 must have a wide swing of voltage in the positive direction in order to turn the NPN transistor 4 on.

During the time period between the initial pumping down of the potential of the P body 12 by the second substrate pump 58, when the first transistor 50 is off, until the time when $V_{DD}$ is supplied to the drain of the first transistor 50, the second transistor 56 and the first substrate pump 54 will have raised the potential of the N well 30 above the potential of $V_{DD}$. If $V_{DD}$ is on order of 5 volts, the second transistor 56 and the first substrate pump 54 will raise it to approximately 8 volts. The mechanism which accomplishes this is as follows: When $V_{DD}$ is initially applied, the second transistor 56 with the gate thereof tied to the drain, will cause the second transistor 56 to conduct, bringing the potential of N well 30 to a threshold below $V_{DD}$, immediately. If $V_{DD}$ is 5 volts, the second transistor 56 will bring it to approximately 4 volts. Thereafter, the first substrate pump 54 needs to pump N well 30 from approximately 4 volts to approximately 8

-11-

volts within the time period under discussion. During this time, the same type of pump must raise the voltage of the gate of the first transistor 50 from approximately 0 volts to approximately 8 volts.

The gate of the first transistor 50 will not be raised until a sufficiently negative voltage is applied to $V_{BB}$ causing ØRES to go low. The N-well 30 will clearly have been raised above $V_{DD}$ when the gate of the first transistor 50 begins its positive transition.

In summary, by the time the first transistor 50 is supplying $V_{DD}$ to the CMOS device 10, both the P body 12, as well as the N well 30, being the substrate connections for the N channel MOS transistor and the P channel MOS transistor, respectively, are sufficiently biased that neither the PNP transistor 2 nor the NPN transistor 4 can turn on, thereby avoiding latchup.

Once power has been applied and the CMOS device 10 is operating in a steady state condition, in the unlikely event that a huge potential swing causes $V_{BB}$ to go from its negative potential to a positive potential, the positive potential of $V_{BB}$ will cause the third depletion transistor 60 to increase in drain current. This causes ØRES to go high. When ØRES goes high, eleventh transistor 76 is turned on, thereby turning off the first transistor 50. Again, this is the situation similar to the initial power-up phase and latchup is avoided because the PNP transistor 2 has no emitter current.

It should be recognized, as previously stated, that the apparatus and the method of the present invention can be applied to either the CMOS device 10 or the CMOS device 110, fabricated into any type of memory, logic or control device.

Furthermore, the apparatus and method of the present invention can be applied by interposing the first transistor 50 between the ground potential and

-12-

the N-channel MOS transistor. The first transistor 50 can be made P-channel and interposed between the ground potential and the source of the N-channel MOS transistor. All of the transistors used to bias the substrates and control the gate of the first transistor 50 should then be P-channel and the signal polarities of control section 52 need to be reversed for this case.

The advantage of the apparatus and method of the present invention is that latchup is avoided during power-up. Moreover, in the unlikely event that conditions, which permit latchup to occur, occur during the steady state operation of the CMOS device, the apparatus will also rectified that condition.

0175152

-13-

Claims

1.  A circuit to prevent latchup in a CMOS device, said CMOS device having at least one P channel MOS transistor and a N channel MOS transistor, each of said transistors having a source, a drain, a gate and a substrate, said device being powered by a voltage source, wherein said circuit comprising:

a first transistor means connected between said voltage source and said CMOS device for connecting and disconnecting said voltage source to said CMOS device;

means for controlling said first transistor means for connecting and disconnecting said voltage source to said CMOS device; and

means for biasing one of the substrates of said P channel transistor or N channel transistor, said controlling means for disconnecting said voltage source to said CMOS device during power up and for connecting said voltage source to said CMOS device after said substrate of said P channel transistor or N channel transistor is biased.

2.  The circuit of Claim 1, wherein said voltage source is a positive voltage source.

3.  The circuit of Claim 2 wherein said first transistor means being connected between said positive voltage source and the source of said P channel MOS transistor.

4.  The circuit of Claim 2 wherein said first transistor means being connected between ground potential and the source of said N-channel MOS transistor.

-14-

5. The circuit of Claim 1 further comprising means for biasing the other of the substrates of said P channel transistor or N channel transistor; and wherein said controlling means for connecting said voltage source to said CMOS device after said substrates are biased.

6. The circuit of Claim 5 wherein said biasing means comprises a first charge pump for applying a positive voltage to the substrate of said P channel MOS transistor and a second charge pump for applying a negative voltage to the substrate of said N channel MOS transistor.

7. The circuit of Claim 1 wherein said controlling means being responsive to a deviation in the voltage of the substrate of one of said P channel MOS transistor or N channel MOS transistor, wherein said controlling means for controlling said first transistor means to disconnect said voltage source to said CMOS device in the event said deviation would cause latchup.

8. The circuit of Claim 7 wherein said controlling means being responsive to the deviation in the voltage of the substrate of said N channel transistor.

-15-

9.    A method of operating a CMOS device to prevent latchup during the application of power to said CMOS device, said CMOS device having a P channel MOS transistor and a N channel MOS transistor, each of said transistors having a source, a drain, a gate and a substrate, wherein said method comprising the steps of:
        biasing one of the substrates of said P channel MOS transistor or said N channel MOS transistor; then
        applying said power to said CMOS device.

10.   The method of Claim 9 wherein said power comprising a positive voltage source being applied to the source of said P channel MOS transistor.

11.   The method of Claim 9 further the step of
        biasing the other substrate of said P channel MOS transistor or said N channel MOS transistor before applying power to said CMOS device.

12.   The method of Claim 11 further comprising the step of
        disconnecting said power to said CMOS device in the event the voltage in the substrate of said N channel MOS transistor would cause latchup.

0175152

112

### FIG.1A.

GND — 18    G    24    D
             22    20

N+    N+

14    16

N-WELL    30

P

10    12

$V_{DD}$

$S(38)$

$G$
$(42)$ ⊢ B(30)

$D(36)$

### FIG.1B

GND — 118    G    124    D
             122    120

N+    N+

114    P-WELL    116

130    N

P+    P+

132    134

138    $V_{DD}$

110    112

$D(20)$

$G$
$(24)$ ⊢ B(12)

$S(18)$

GND

### FIG.2.

### FIG.3.

$V_{DD}$    $V_{DD}$

PNP    2    N-WELL $\left(\begin{smallmatrix}FIG.2\\N\text{-}BODY\end{smallmatrix}\right)$

P BODY
(P-WELL)
FIG.2

NPN

4

GND

GND

FIG.4.

FIG.5.

FIG.6.

FIG.7.